Europäisches Patentamt

European Patent Office

Office européen des brevets

(11) Publication number: **0 342 818 A2**

## EUROPEAN PATENT APPLICATION

(21) Application number: **89304456.0**

(22) Date of filing: **03.05.89**

(51) Int. Cl.⁴: **H05K 13/04**

(30) Priority: **19.05.88 US 193344**

(43) Date of publication of application:
**23.11.89 Bulletin 89/47**

(84) Designated Contracting States:
**DE FR GB**

(71) Applicant: **EMHART INDUSTRIES, INC.**
**426 Colt Highway**
**Farmington Connecticut 06032(US)**

(72) Inventor: **Mirley Jr., William H.**
**222A Haverhill Street**
**North Reading Massachusetts 01864(US)**
Inventor: **McLean, Jean A.**
**17 Howard Street**
**South Hamilton Massachusetts 01982(US)**

(74) Representative: **Stagg, Diana Christine et al**
**Emhart Patents Department Lyn House 39**
**The Parade**
**Oadby Leicester LE2 5BB(GB)**

(54) **Electronic component insertion machine.**

(57) A machine for inserting DIP components having different centre spacings. The magazine has a number of component magazines (30) dedicated to components of one size. The central processing unit retains the data concerning the centre spacing for each of the magazines from the previous insertion program (LAST PROGRAM MAGAZINE DATA LIBRARY) and compares this data with similar data for the next insertion program (NEW PROGRAM MAGAZINE DATA LIBRARY). If the next program requires a change in one of the magazines (a small component magazine must be changed to a large component magazine for example), the centre spacing data for the last and next programs is visually presented (38) in an adjacent format to alert the operator that a change was required.

**FIG. 1**

## ELECTRONIC COMPONENT INSERTION MACHINE

A dual in-line package (DIP) electronic component insertion machine inserts DIP components into a supported circuit board. Such a machine includes a plurality of component magazines having a number of raceways each containing a particular component having a specific centre spacing (C.S.). DIP components may have a variety of centre spacings (7.6 mm or 15.2 mm (.300 inch C.S. or .600 inch C.S.) for example), but conventionally, all raceways of a given magazine will hold components having the same centre spacing.

In U.S. Patent No. 4,450,619, two locating pins on each magazine actuate associated switches to indicate to the computer control the centre spacing of the components contained in the magazine so that other portions of the machine can be adjusted to match the components in that magazine.

It is an object of the present invention to provide a system for assuring that the component centre spacing of the magazines is correct.

The present invention provides a machine for inserting dual in-line package (DIP) components having first and second centre spacings into a supported circuit board, the components being inserted during production runs in accordance with an insertion program comprising a plurality of magazines, at least one of the magazines adapted to contain components having the first centre spacing and, at least one of the magazines adapted to contain components having said second centre spacing, characterised in that the machine further comprises means (LAST PROGRAM MAGAZINE DATA LIBRARY) for storing the centre spacing data for the plurality of magazines adapted to contain components having the first and second centre spacings for the insertion program of the last production run, means (NEW PROGRAM MAGAZINE DATA LIBRARY) for storing the centre spacing data for the plurality of magazines adapted to contain components having the first and second centre spacings for the insertion program for the production run which is to be now started, means for comparing (COMPARATOR) the last data and the next data, and means for presenting the data of the last production run and of the production run which is now to be started when the data is different so that an operator will be alerted to change at least one of the magazines.

The machine according to the invention for inserting dual in-line package components preferably further comprises first inserting means for inserting DIP components having the first centre spacing and second inserting means for inserting DIP components having the second centre spacing.

The present invention will now be described with reference to the accompanying drawings, which illustrate a preferred embodiment of the invention.

Referring to the drawings:

Figure 1 is an oblique view of a portion of an embodiment of a DIP electronic component insertion machine according to the present invention;

Figure 2 is an oblique schematic view of another portion of the machine;

Figure 3 is a block diagram of another portion of the machine; and

Figure 4 is a flowchart illustrating the operation of the machine.

The component insertion machine has a pair of insertion stations 10, 12 each dedicated to a component having a specific size. As illustrated, the left hand station 10 handles DIP components 14 having a first centre spacing (lead to lead spacing of 15.2 mm (.600 inch), for example) while the right hand station 12 handles DIP components 16 having a smaller centre spacing (7.6 mm (.300 inch), for example). Each station has an insertion mechanism including a pair of grippers 18 which grip the component. The gripped component is lowered until the component leads 19 are partially inserted into receiving holes in a supported circuit board 20. The grippers release the partially inserted component and a pusher (not shown) is lowered fully to seat the component (the insertion heads operate sequentially following circuit board displacement to position the circuit board at the proper component receiving position). Once inserted, the associated cut and clinch mechanism 22 cuts the fully inserted leads 19 to size and crimps the leads to secure the component to the circuit board.

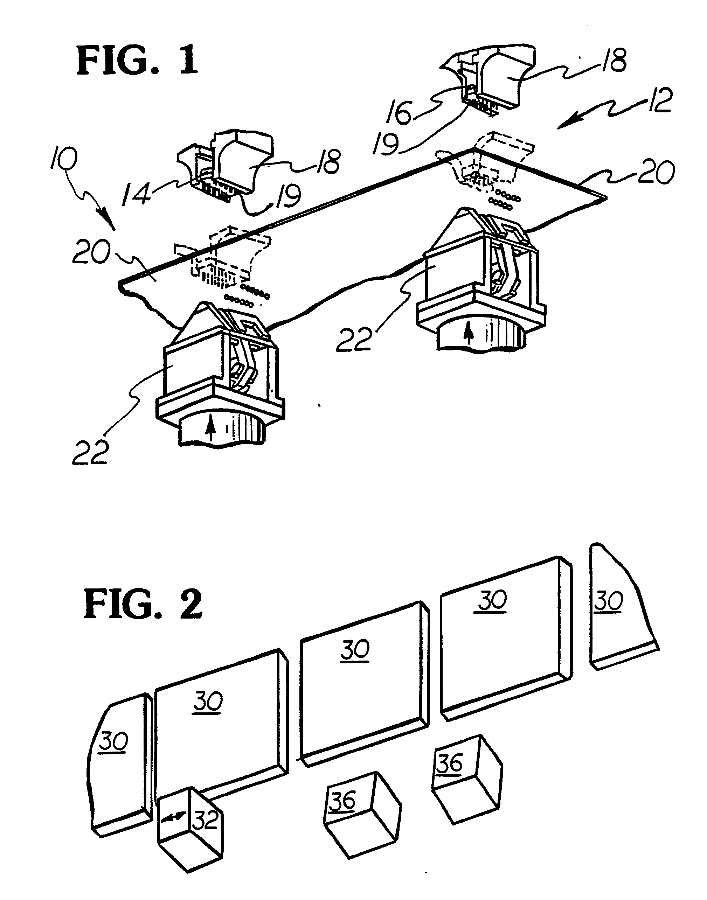

The electronic component insertion machine also has a plurality (five in the embodiment illustrated) of magazines 30 (Figure 2) each of which has a number of raceways (not shown). Each raceway contains like components and the components of all of the raceways in a particular magazine have the same centre spacing. A picker 32, which is displaceable along the magazine 30 picks or accepts individual components from the raceways and transports and deposits the selected components in a feeder unit 36 (one for each insertion location) which feeds the component to the insertion head where it is gripped by the grippers 18. Details of a conventional picker and feeder are illustrated in U.S. Patent No. 4,450,619.

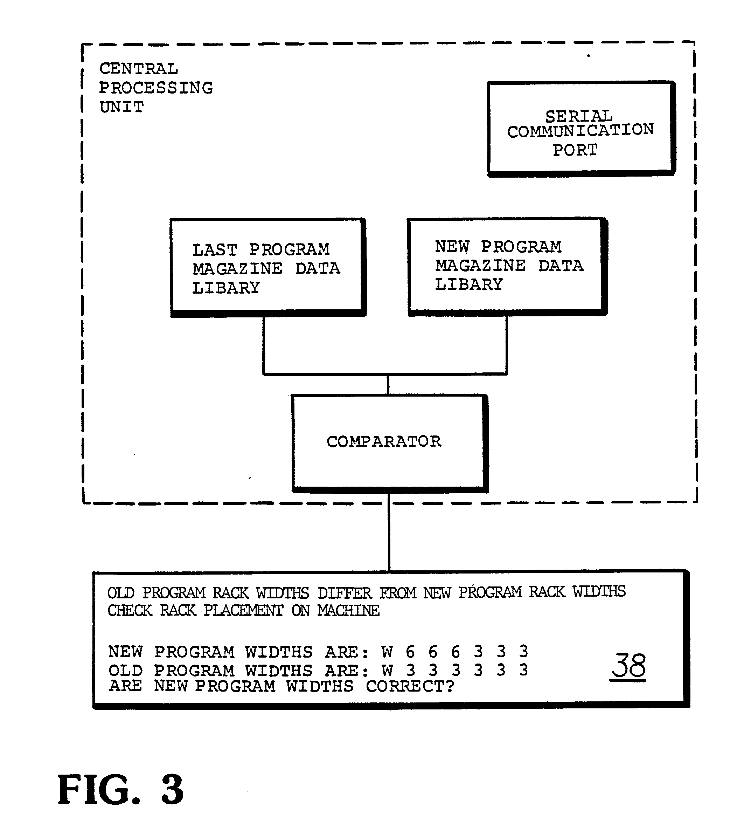

The insertion program for a particular circuit board is stored on a suitable medium (a tape or floppy disc, for example) and is inputted to the Central Processing Unit for the machine (Figure 3) through a serial communication port. The Computer Processing Unit also includes a pair of libraries which contain the centre spacing data for the magazines in the machine. The Last Program Magazine Data Library contains this data for the last insertion program in the non-volatile memory, and the Next Program Magazine Data Library contains this data for the next insertion program. A Comparator compares this data, and if there is any difference, presents the magazine data for the last and next programs on a CRT screen 38 in an adjacent format to confront the operator with any disparity and asks the operator whether the new program widths are correct. This presentation alerts the operator to the fact that one or more of the magazines or racks having one centre spacing should have been replaced by racks having the second centre spacing. If the operator has already made this change, this discrepancy can be ignored. If not, the operator will make the required change.

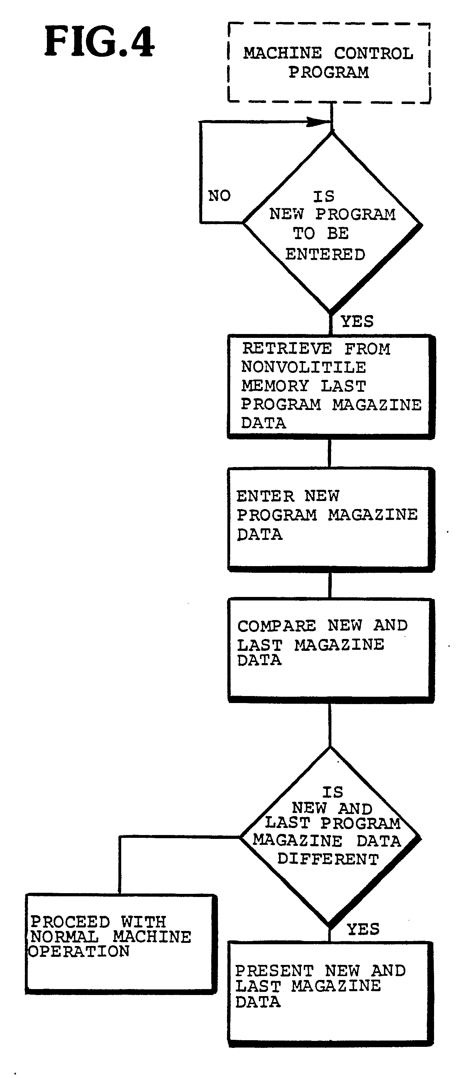

Whenever an insertion program is transmitted to the computer, the new program magazine data is compared with the last program magazine data retrieved from resident non-volatile memory (see the basic flowchart illustrated in Figure 4) and presents the alert referred to above if there are differences in the magazine data. The contents of the new program magazine data file is then entered into the old program magazine data file, overwriting the old contents. In effect, the new program magazine data now becomes the old program magazine data.

## Claims

1. A machine for inserting dual in-line package (DIP) components having first and second centre spacings into a supported circuit board, the components being inserted during production runs in accordance with an insertion program comprising
a plurality of magazines (30),
at least one of the magazines (30) adapted to contain components having the first centre spacing and,
at least one of the magazines (30) adapted to contain components having the second centre spacing,
characterised in that the machine further comprises
means (LAST PROGRAM MAGAZINE DATA LIBRARY) for storing the centre spacing data for the plurality of magazines adapted to contain components having the first and second centre spacings for the insertion program of the last production run,
means (NEW PROGRAM MAGAZINE DATA LIBRARY) for storing the centre spacing data for the plurality of magazines adapted to contain components having the first and second centre spacings for the insertion program for the production run which is to be now started,
means for comparing (COMPARATOR) the last data and the next data, and
means (38) for presenting the data of the last production run and of the production run which is now to be started when the data is different so that an operator will be alerted to change at least one of the magazines.

2. A machine according to claim 1, further characterised in that it comprises
first inserting means (22) for inserting DIP components having the first centre spacing, and
second inserting means (22) for inserting DIP components having the second centre spacing.

# FIG. 1

# FIG. 2

CENTRAL
PROCESSING
UNIT

SERIAL
COMMUNICATION
PORT

LAST PROGRAM
MAGAZINE DATA
LIBARY

NEW PROGRAM
MAGAZINE DATA
LIBARY

COMPARATOR

OLD PROGRAM RACK WIDTHS DIFFER FROM NEW PROGRAM RACK WIDTHS
CHECK RACK PLACEMENT ON MACHINE

NEW  PROGRAM WIDTHS  ARE:  W 6 6 6 3 3 3
OLD  PROGRAM WIDTHS  ARE:  W 3 3 3 3 3 3          38
ARE  NEW PROGRAM WIDTHS  CORRECT?

# FIG. 3

# FIG.4

```
┌ ─ ─ ─ ─ ─ ─ ─ ─ ┐
  MACHINE CONTROL
     PROGRAM
└ ─ ─ ─ ─ ─ ─ ─ ─ ┘
```

IS NEW PROGRAM TO BE ENTERED

NO

YES

RETRIEVE FROM NONVOLITILE MEMORY LAST PROGRAM MAGAZINE DATA

ENTER NEW PROGRAM MAGAZINE DATA

COMPARE NEW AND LAST MAGAZINE DATA

IS NEW AND LAST PROGRAM MAGAZINE DATA DIFFERENT

PROCEED WITH NORMAL MACHINE OPERATION

YES

PRESENT NEW AND LAST MAGAZINE DATA